(19) Europäisches Patentamt
European Patent Office
Office européen des brevets

(11) **EP 4 187 274 A1**

(12) **EUROPEAN PATENT APPLICATION**

(43) Date of publication:
**31.05.2023 Bulletin 2023/22**

(21) Application number: **22207872.7**

(22) Date of filing: **16.11.2022**

(51) International Patent Classification (IPC):
**G01S 7/03** *(2006.01)*      *G01S 13/86* *(2006.01)*
**G01S 13/931** *(2020.01)*

(52) Cooperative Patent Classification (CPC):
**G01S 7/032;** G01S 13/86; G01S 13/865;
G01S 2013/9316; G01S 2013/9318;
G01S 2013/93185; G01S 2013/9319

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.11.2021 US 202117535017**

(71) Applicant: **GM Cruise Holdings LLC**
**San Francisco, CA 94107 (US)**

(72) Inventor: **TAPIA, Daniel Flores**
**California (US)**

(74) Representative: **Barton, Russell Glen**
**Withers & Rogers LLP**
**2 London Bridge**
**London SE1 9RA (GB)**

(54) **MODULAR RADAR ELEMENT WIRELESS SYNCHRONIZATION**

(57)    The present disclosure is directed to a modular radar apparatus and to methods for using a modular radar apparatus. Two or more modules (120, 130, 140) of the radar apparatus may each include a reference signal antenna (120-R, 130-R, 140-R) where a synchronization signal generated at a first module may be sent to a second module via a pair of respective reference signal antenna. When the synchronization signal is received by the second module, that signal may be provided to a phase locked loop (PLL) to synchronize timing of the second module with the first module. The PLL or a multiplier circuit could then generate signals with timing synchronized to the synchronization signal yet at frequencies higher than the synchronization signal. This synchronized timing may allow transmitted radar signals to be synchronized in time with received reflected radar signals more accurately because effects of transmitting synchronization signals via wired interconnects between modules is eliminated.

FIG. 1

EP 4 187 274 A1

## Description

## BACKGROUND

### 1. Technical Field

The disclosed technology is directed to improvements of radar systems. More specifically the present disclosure is directed to modular radar apparatus and methods for using modular radar devices.

### 2. Introduction

Autonomous vehicles (AVs) are vehicles having computers and control systems that perform driving and navigation tasks that are conventionally performed by a human driver. As AV technologies continue to advance, they will be increasingly used to improve transportation efficiency and safety. As such, AVs will need to perform many of the functions that are conventionally performed by human drivers, such as performing navigation and routing tasks necessary to provide a safe and efficient transportation. Such tasks may require the collection and processing of large quantities of data using various sensor types, including but not limited to cameras and/or Light Detection and Ranging (LiDAR) sensors, and radar elements disposed on the AV.

Current automotive radar boards are custom designed and built with little or no room for antenna layout upgrades. Commonly radar apparatus used in an AV include a single assembly (e.g. a single printed circuit board) that may include many different radar antennas. These different antennas may be designed to operate within a set of constraints that are believed to be adequate to meet the needs of users of the radar apparatus. In certain instances, the testing or use of a radar apparatus identify that the radar apparatus is not sufficiently meeting user needs. This may result in designers of the radar apparatus realizing that a whole new design of the radar apparatus is needed because the radar apparatus is built within a single assembly or circuit board. This leads to the locking of radar board configurations, because once a design that includes several radar elements is made, it is difficult, expensive, and time consuming to modify or replace an existing design. This is especially true when a redesign processes requires changes in a number of antenna elements or requires changes specific antenna elements to be moved or changed in some way.

What are needed are new apparatus and methods that decouple the design of specific radar circuits or antenna elements from the design of other radar circuits or antenna elements included in a radar elements.

## BRIEF DESCRIPTION OF THE DRAWINGS

Certain features of the subject technology are set forth in the appended claims. However, the accompanying drawings, which are included to provide further understanding, illustrate disclosed aspects and together with the description serve to explain the principles of the subject technology. In the drawings:

FIG. 1 illustrates modular radar apparatus that includes a plurality of physically connected electronic modules.
FIG. 2A illustrates a first and a second electronic of module that may be included in the apparatus of FIG. 1.
FIG. 2B illustrates the electronic modules of FIG. 2A that are arranged one orientation of a plurality of possible orientations.
FIG. 3 illustrates a series of steps that may be performed when a radar apparatus is used.
FIG. 4 illustrates an example system environment that can be used to facilitate AV dispatch and operations, according to some aspects of the disclosed technology.
FIG. 5 illustrates an example processor-based system with which some aspects of the subject technology can be implemented.

## DETAILED DESCRIPTION

The detailed description set forth below is intended as a description of various configurations of the subject technology and is not intended to represent the only configurations in which the subject technology can be practiced. The appended drawings are incorporated herein and constitute a part of the detailed description. The detailed description includes specific details for the purpose of providing a more thorough understanding of the subject technology. However, it will be clear and apparent that the subject technology is not limited to the specific details set forth herein and may be practiced without these details. In some instances, structures and components are shown in block diagram form in order to avoid obscuring the concepts of the subject technology.

As described herein, one aspect of the present technology is the gathering and use of data available from various sources to improve quality and experience. The present disclosure contemplates that in some instances, this gathered data may include personal information. The present disclosure contemplates that the entities involved with such personal information respect and value privacy policies and practices. One aspect of the present technology is a set of modular radar elements that communicate synchronization signals between various modules wirelessly via one or more reference signal antennas. A reference signal may be generated at one module and then be transmitted to one or more other modules via one or more reference signal antennas. Here one of the modules may be designated as a primary or master module that provides synchronization signals to one or more secondary modules via one or more antennas. A synchronization signal generated at a primary master module may be generated using various methods. The synchronization signal could be generated using a tuned oscillator, a voltage-controlled oscillator, or a phase locked loop (PLL).

Two or more modules of the radar apparatus may each include a reference signal antenna where a synchronization signal generated at a first module may be sent to a second module via a pair of respective reference signal antenna. When the synchronization signal is received by the second module, that signal may be provided to a phase locked loop (PLL) to synchronize timing of the second module with the first module. The PLL or a multiplier circuit could then generate signals with timing synchronized to the synchronization signal yet at frequencies higher than the synchronization signal. This synchronized timing may allow transmitted radar signals to be synchronized in time with received reflected radar signals more accurately because effects of transmitting synchronization signals via wired interconnects between modules is eliminated.

As mentioned above, when a first module transmits a generated reference signal to a second module, a phase locked loop (PLL) located at the second module may be used to synchronize timing between the first and the second module. One of ordinary skill in the art at the time of the invention would understand that a PLL may be made using one or more discrete components or may be include within a larger integrated circuit. Typically a PLL will include an input where a reference signal is received and a frequency/phase comparator that compares a frequency and/or phase of a signal generated by a volage controlled oscillator (VCO) with a frequency and a phase of a received reference signal. For example, a primary synchronization signal may be generated at a primary electronic module and be provided to a secondary electronic module via respective antennas located at the primary and the secondary electronic modules. Once received by the secondary module, the synchronization signal may be provided to the aforementioned frequency/phase comparator. Next, a difference signal generated by the frequency/phase comparator may be provided to a filter, and a signal output from the filter may be provided to an input of a VCO. A magnitude of voltage provided to the input of the VCO will force the frequency or phase of the VCO to change until a frequency/phase error between the VCO signal and the reference signal reduce to a minimal acceptable level.

An output of the VCO may then be provided to a frequency multiplier that generates one or more signals that are a multiple of the frequency of the VCO frequency. Here a phase of the frequency multiplied signal will correspond to a phase of the signal generated by the VCO yet may be of a higher frequency than the frequency of the VCO frequency. This higher frequency allows other circuits to resolve timing to a much higher level than is possible using the frequency of the VCO to measure timing directly.

As mentioned above, a single master electronic module may provide synchronization signals to a plurality of different secondary electronic modules. The master electronic module may provide a synchronization signal to each respective secondary electronic module via a different antenna. A strip line located at the master electronic module may provide the synchronization signal to respective antennas in either serial or parallel fashion. A serial configuration may include a set of are distributed along the length of a trace. A parallel configuration may include antennas distributed along different traces, using various topologies. In one instance, a parallel configuration may distribute the synchronization signal to different traces of a same length (e.g. using a star configuration). In other instances, a parallel configuration may distribute the synchronization signal using traces of different lengths.

Different trace lengths and potentially other factors could result in synchronization signals being distributed with slightly different timing. This is because values of impedance of a distribution line results in high frequency signals being delayed. Often, such delays are primarily based on trace lengths. Lengths of signal distribution traces of particular widths (e.g. strip line traces in proximity to a dielectric and/or a ground plane) affect the impedance of a trace which in turn results in time delays that increase with trace length. This means that different respective antennas could receive synchronization signals with slightly different phases. Trace length differences at respective secondary modules can also affect relative signal timing. These factors could mean that particular trace layouts at different modules could result in timing skews or errors because of different delays associated with topologies of different electronic modules. In instances when trace length and delay characteristics associated with respective electronic modules are known, these delays could be corrected by compensating for an anticipated delay by offsetting timing by a timing phase offset.

In certain instances, a reference (i.e. synchronization) signal may have a frequency between about 4.5 gigahertz (GHz) and 9 GHz and multiplied timing signals may have a frequency of 38 GHz, 76 GHz, or 77 GHz. For example, for a strip line trace of a printed circuit board (PCB) is associated with a measure of time delay per inch (Tpd) in picoseconds per inch of 85 times the Square root of a dielectric constant (Er), this means the value of delay in picoseconds per inch for a strip line trace can be calculated using the formula:

$$Tpd = 85 \, (Er)^{1/2}$$

For standard FR4 circuit boards (a commonly used glass-reinforced epoxy laminate material) the values dielectric constant Er is equal to 4.3 and delay per inch and an associated delay per inch of strip line trace would result in a delay of about 176.26 picoseconds. In an instance when the reference (synchronization) signal has a frequency of 9 GHz, calculations may be performed to identify a phase error induced by a delay of 176.29 picoseconds, since a 9 GHz signal has a time periodicity inversely proportional to a value of 9 trillion, one period of this signal has a time period of 111 picoseconds. Since 176.29/111 = 1.588, a one-inch stirp line trace would induce a delay of about 1.588 periods of the 9 GHz signal. Such timing skews could potentially result in a radar apparatus making errors regarding the location of an object. Even small timing errors could potentially result in an autonomous vehicle coming unsafely close to or impacting an object.

Two ways to mitigate these offsets is to use very short trace lengths, or to use equal trace lengths for all relevant signal paths. These methods, however, result in adding constraints to a design and these methods would not compensate for variations in manufactured circuit assemblies. Another way that timing differences could be mitigated is for a system to be aware of respective trace lengths and compensate for the timing differences by compensating for the timing difference in the analog domain (using delaylines) or in the digital domain by adjusting the timing by adding or subtracting a delay time to a signal. While timings associated with variations in manufacturing might likely not be significant enough to be a concern, manufacturing processes could be used to measure trace delay associated with particular traces when a module was manufactured and the measured delay time could be programmed into a non-volatile memory of the module such that a measured delay time could be used to make timing adjustments when received reflected radar signals were analyzed.

Each of the respective modules in an apparatus may also include a transmission antenna that may transmit radar signals and receive reflections of the transmitted radar signals after they bounce off objects located in front of or around a respective radar module. A plurality of modules may be configured to transmit radar signals that have the same characteristics or that may have different characteristics and then receive reflected radar signals such that those signals can be analyzed.

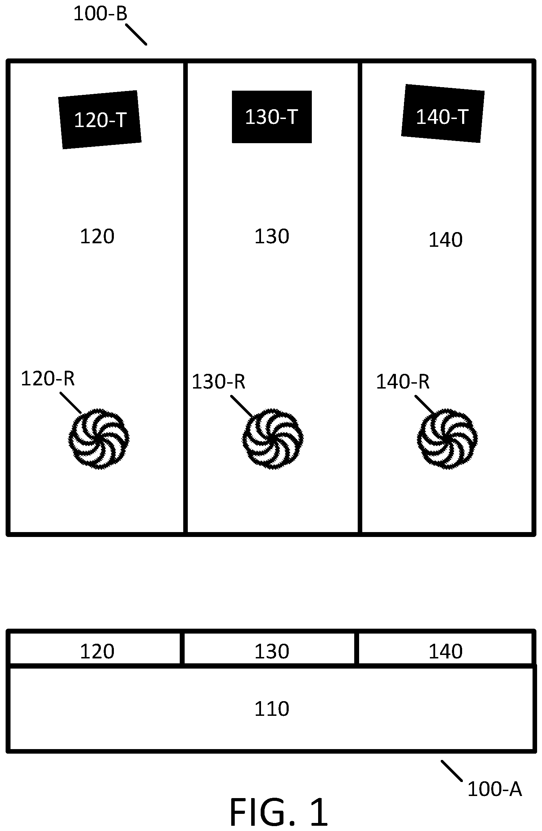

FIG. 1 illustrates modular radar apparatus that includes a plurality of physically connected electronic modules. FIG. 1 includes a set of electronic modules 110, 120, 130, and 140. Here module 110 may be a base electronic module that performs tasks based on data received from modules 120, 130, and 140. The apparatus of FIG. 1 includes two different views of the modular radar apparatus, a side view 100-A and a top view 110-B.

The side view 110-A of the modular radar apparatus of FIG. 1 shows electronic modules 123, 130, and 140 stacked on top of electronic module 110. Module 110 may be configured to perform signal processing tasks using data received from each of modules 120, 130, and 140. In certain instances, some of the modules of FIG. 1 may include radar transmission and/or receiver antennas. In other instances, all of the modules of FIG.

1 may include a respective radar transmission and/or receiver antennas.

The top view 100-B of FIG. 1 illustrates electronic modules 120, 130, and 140 positioned next to each other. Here each of the electronic modules 120, 130, and 140 include a respective radar transmission antenna (120-T, 130-T, & 140-T) and a respective reference signal antenna (120-R, 130-R, & 140-R). Module 120 includes radar transmission antenna 120-T and reference signal antenna 120-R. Module 130 includes radar transmission antenna 130-T and reference signal antenna 130-R. Module 140 includes radar transmission antenna 140-T and reference signal antenna 140-R. In certain instances, the different radar transmission antennas of FIG. 1 may point in a slightly different direction. Note that radar transmission antenna 120-T points in a slightly leftward direction, that radar transmission antenna 130-T points in a forward direction, and that radar transmission antenna 140-T points in a forward direction. Data received from the different radar transmission antennas may act as a phased-array radar that allows signal processors to generate images of objects in three-dimensional (3D) space. The modular radar assembly of FIG. 1 may include one or more antennas that transmit radar energy and several different antennas that receive reflected radar energy. For example, module 110 could include a radar transmitting antenna that sends out radar energy and radar transmitting antennas 120-T, 130-T, and 140-T may receive reflected radar energy that was transmitted by the radar transmitting antenna in module 110. In other instances, each of the radar transmitting antennas of FIG. 1 (120-T, 130-T, and 140-T) may both transmit and receive radar energy.

Each of the different radar transmission antennas (120-T, 130-T, & 140-T) may transmit radar signals and receive radar energy that has been reflected off of objects located in front of or around each of the respective radar transmission antennas (120-T, 130-T, & 140-T). Each of the different reference signal antennas (120-R, 130-R, & 140-R) may receive a reference signal from module 110. As mentioned above these reference signals may be used to synchronize timing between the different modules.

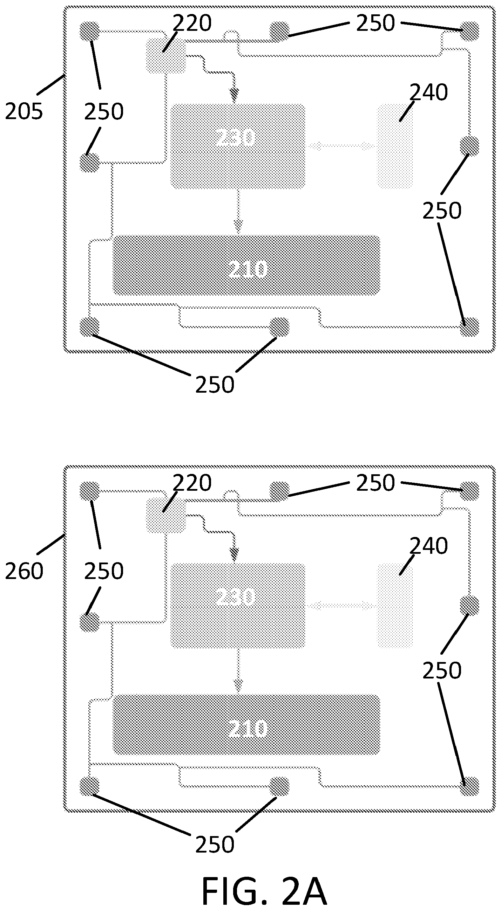

FIG. 2A illustrates a first and a second electronic of module that may be included in the apparatus of FIG. 1. The first electronic module 205 of FIG. 2A includes radar transmitting antenna 210, amplifier 220, circuitry (IC) 230, signal generator or phase locked loop (PLL) 240, and reference signal antennas 250. The second electronic module 260 of FIG. 2A includes these same elements, radar transmission antenna 210, amplifier 220, circuitry (IC) 230, PLL/signal generator 240, and reference signal antennas 250.

In operation, a signal generated by signal generator/PLL 240 of electronic module 205 may be provided to electronic module 260 with a synchronization signal via one of the reference signal antennas 250 of module 205 and one of the reference signal antennas 250 of module 240. The synchronization signal transmitted from module 205 and received by module 240 may be provided to the PLL 240 of module 260 to synchronize the timing of an oscillator of PLL 240 of module 260 with timing of signal generator/PLL 240 of module 205. Once synchronized, timing signals of module 205 and timing signals of module 240 would have a stable phase relationship with each other. In certain instances, as discussed above a phase error may still exist between the timing signals of module 205 and module 240, even so, this phase error may be predictable and may be kept withing a threshold margin based on the operation of PLL 240 or may be compensated for by other means (analog or digital). Here the synchronization signal transmitted via respective reference signal antennas may be in the form of a sinewave. In certain instances, reference signal antenna may be used to transmit data that has been encoded into the synchronization signal. Because of this, synchronization signals may both provide timing synchronization and data communication between modules.

Circuitry 230 may be configured to provide radar signals of specific frequencies to emit radar energy. For example, a 77 GHz radar signal may be used. Circuity 230 may include timing elements that multiply the frequency of an oscillator of a PLL 240 or a signal coupled to PLL 240. A reference signal provided to PLL 240 of module 260 may have a frequency of 9 GHz, as discussed above. Circuitry 230 may also include a memory and a processor that may be configured to perform signal processing tasks and control frequencies of transmitted radar energy or pulse rates of transmitted radar energy. Signals generated by circuitry 230 may be provide to amplifier 220 and then to transmission antenna element 210 to transmit radar energy signals of a controlled power and frequency and/or pulse rate. Transmission antenna element 210 of module 260 may also receive radar energy that was reflected from an object and this reflected radar energy may be passed through amplifier 220 to circuitry 230 for signal processing at module 260. Timing circuits of circuitry 255 may be used to identify moments in time when the reflected radar energy was received. Data characterizing the reflected energy may be digitized, possibly with an analog to digital converter and this digital data may be associated with a timestamp. This data may identify a magnitude of the reflected radar energy and possibly other characteristics of the reflected radar energy from which a size of the object, a location of the object, and a distance associated with the object may be identified. Here frequencies of transmitted radar energy may be changed based on vehicle speed, where the slower the vehicle is traveling could result in a lower frequency of radar energy being transmitted from transmission antenna elements 210 and where the faster the vehicle is traveling would result in a higher frequency of radar energy being transmitted from transmission antenna elements 210.

Once the data has been digitized, it may be transmitted to electronic module 205 via a direct electrical interconnect or via near field data communication transceivers 245. It is envisioned that all the elements may be built withing a same enclosure. When wireless transceivers are used, they may be in the form of wireless inductive elements (e.g. coils), transmission antenna, or optical transceivers. When antennas are used, they should be aligned in such a way that transmit/receive pattern overlap is maximized. Data may be transmitted by one element on one module and may be received by another element on a second module based on these elements being located in a close proximity or controlled location relative to each other. Here wireless transceivers may be aligned and data may be transmitted wirelessly between modules based on alignment of respective wireless transmitters. In instances when optical transceivers are used, they may be in the form of LiFi transceivers or light emitting diodes and light sensitive elements that communicate data using light. The board design should be made considering an ideal number of locations to maximize the number of mounting options to maximize the architecture flexibility of the system.

Circuitry 230 at electronic module 205 may then perform other evaluations or signal processing tasks. The various components of circuitry 230, amplifier 220, and transmission antenna element 210 of module 205 may perform actions similar to those discussed in respect to circuitry 230, amplifier 220, and transmission antenna element 210 of module 260.

Circuitry 230 of module 205 may evaluate data associated with reflected radar energy detected by circuits of module 260, module 205, and possibly other electronic modules not illustrated in FIG. 2A. This could allow circuitry 220 of module 205 to more precisely identify a location, a size, and a distance to an object than is possible using only a single radar transmitter. This is because the different radar transmitters and reflections received by those transmitting elements may act similar to a pair or set of eyes that can resolve distances based on a differential analysis.

A respective electronic module may receive data from a different radar module using signals coupled using a mechanical direct electrical connector or via paired wireless data transceivers. Each of these different interconnects or transceivers may receive from and may possibly transmit data to respective modules once those modules are aligned and connected to each other. In certain instances, electronic module 205 may not include a radar transmission antenna element or an amplifier. In such an instance, module 205 may be dedicated to transmitting synchronization signals and to processing data received from other modules. Module 205 may only include a single reference signal antenna that is configured to transmit a synchronization signal to multiple different modules in parallel.

Offsets in timing may be corrected by operations performed at either the circuitry 230 of module 205 or the circuitry 230 of module 260. Each of a set of modules may be aligned and rigidly attached to other respective modules such that one reference signal antenna 250 of module 205 is aligned with a reference signal antenna 250 of module 260. This alignment may also align direct electrical signal interconnects or wireless transceivers at modules that are built into a radar apparatus. Physical shapes and dimensions of the respective modules could allow these modules to be aligned and physically connected much like a set of Lego blocks. Interconnects or wireless transceivers could be used to transmit data to or receive data from another module that informs circuity at respective modules of delay characteristics (e.g. trace length, time delay, or a number that corresponds to a time delay) of those respective modules. This could allow time stamps generated by or received from respective modules to be offset based on the delay characteristics of those specific modules.

Here a memory at a respective module may store a delay time that may be used to offset timing of signals. In other instances, a type of module may be associated with specific time delays. This would allow for any module selected by a designer to offset timing in a manner that the designer prefers. Circuitry 230 and these electronic modules may include a Monolithic Microwave Integrated Circuit (MMIC) that may perform the functions of frequency multiplication, radar signal generation, and/or analysis of received radar signals. Circuitry 230 at these modules may include one or more of a memory and a processor, an application specific integrated circuit (ASIC), a field programmable gate array (FPGA), or other circuits. Processors used to perform signal analysis may be any type of processor known in the art, such as a conventional processor or multi-processor, a graphic processing unit (GPU), a digital signal processor (DSP), or a combination of different types of processors.

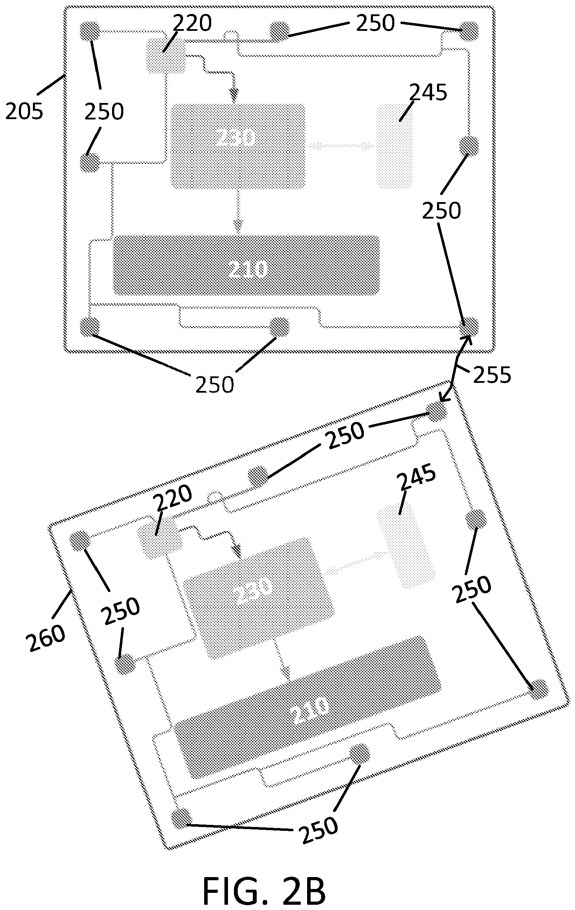

FIG. 2B illustrates the electronic modules of FIG. 2A that are arranged in one orientation of a plurality of possible orientations. Here, the transmitting antenna 210 at electronic module 205 may be configured to direct radar energy in a leftward direction. Electronic modules 205 and 260 may be arranged in the configuration of FIG. 2B, where module 260 is rotated in a counterclockwise direction as compared to module 205. This would allow transmitting antenna 210 of electronic module to transmit radar signals toward the left bottom direction of FIG. 2A.

The electronic modules 205 & 260 of FIG. 2B include all of the elements of the electronic modules 205, & 260 of FIG. 2A. Once again, these elements include radar transmitting antenna 210, amplifier 220, circuitry (IC) 230, signal generator or phase locked loop (PLL) 240, direct electrical interconnect or via wireless data communication transceivers 245, and reference signal antennas 250.

FIG. 2B illustrates that a particular reference signal antenna of module 205 is sending a synchronization signal to a specific reference signal antenna of module 260 via signal 255. As mentioned above such a synchronization signal may also be used to transmit data between modules. Alternatively, or additionally, when item 245 of FIG. 2A/2B transmit and receive data wirelessly (wireless transceivers), these wireless transceivers may send data between modules based on a proximity or location associated with the modules. For example, the wireless transceivers may be aligned sufficiently such that the wireless data signals transmitted by on module can efficiently be received by another module.

The various modules of FIGS. 2A & 2B may be configured to be aligned and connected in a plurality of different directions to optimize a particular radar apparatus to a specific vehicle or application. The modular nature of this approach also allows for new electronic modules to be quickly designed, built, and be connected to older electronic modules to update how a particular radar apparatus operates. This approach allows new radar apparatus to be built without having to redesign a plurality of sets of radar electronics that may be included in a radar apparatus. This modular approach also may allow the number of electronic modules included in an updated radar apparatus to be easily increased. For example, when a first radar apparatus included two electronic modules, functionality of that radar apparatus could be expanded by adding a third electronic module.

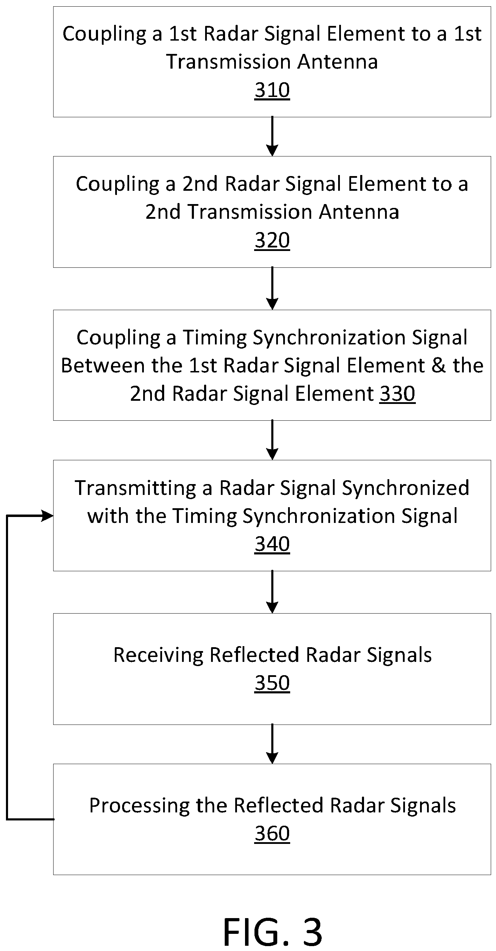

FIG. 3 illustrates a series of steps that may be performed when a radar apparatus is used. Step 310 of FIG. 3 is where a first radar signal element is coupled to a first transmission antenna. This first radar signal element may include components discussed in respect to the electronic module 205 of FIG. 2, where signal generator/PLL 240, circuits 230, and amplifier 220 may be coupled to radar transmitting element 210 such that radar signals may be transmitted from radar transmitting element 210. This first radar signal element may also include one or more reference signal 250 that may be configured to transmit a synchronization signal to another electronic module.

Next step 320 of FIG. 3 may include coupling a second radar signal element to a second transmission antenna. This second radar signal element may include components discussed in respect to the electronic module 260 of FIGS 2A/2B, where PLL/signal generator 240, circuits 230, and amplifier 220 may be coupled to radar transmitting element 210 such that radar signals may be transmitted from radar transmitting element 210 of module 260. This second radar signal element may also include reference signal antennas that may be configured to receive a synchronization signal from another electronic module. The coupling of these synchronization signals may be based on physical alignment of reference signal antennas of different modules.

After step 320, timing synchronization signals may be transmitted between the first radar signal element and the second radar signal element in step 330 of FIG. 3. This may include transmitting the timing synchronization signal from electronic module 205 via any one of reference signal antennas 250 of module 205 and receiving the timing synchronization signal at electronic module 260 via respective reference signal antennas 250 of module 260. As discuss above, the synchronization signals shared between the different electronic modules allows timing of the modules to be synchronized such that the timing of transmitted radar signals may be synchronized with the timing of reflected radar signals such that a timing analysis can be performed.

Next in step 340, a radar signal may be transmitted and reflected radar signals may then be received in step 350. Here the timing of the transmitted radar signal may have a timing that is synchronized with the timing synchronization signal coupled between the first and second radar signal elements in step 330 of FIG. 3. After the reflected radar signals are received, those reflected radar signals may be processed in step 360. The method of FIG. 3 may then move back to step 340 where another radar signal is transmitted.

Radio Detection and Ranging (radar) sensors collect data about an environment by receiving reflected electromagnetic waves that can be used to determine certain properties about the reflecting objects. Radar sensors can be used to measure location parameters for various objects, including an angle of azimuth, a range, and an elevation. In common deployments, elevation measurements can indicate an object location along a vertical axis, e.g., with respect to the ground. However, depending on the desired orientation of the radar's antennae, elevation measurements can be used to generate location measurements along other axial orientations or directions.

In some radar deployments, elevation measurements can be noisy, as compared to measurements for azimuth and range. By way of example, in typical radar deployments, elevation errors can commonly be in the range of $\pm$ 20 meters of an object's actual location. Due to the measurement error attendant in radar elevation measurements, radar signals have limited use for applications in which highly accurate localization information is needed, such as in the deployment of autonomous vehicles (AVs).

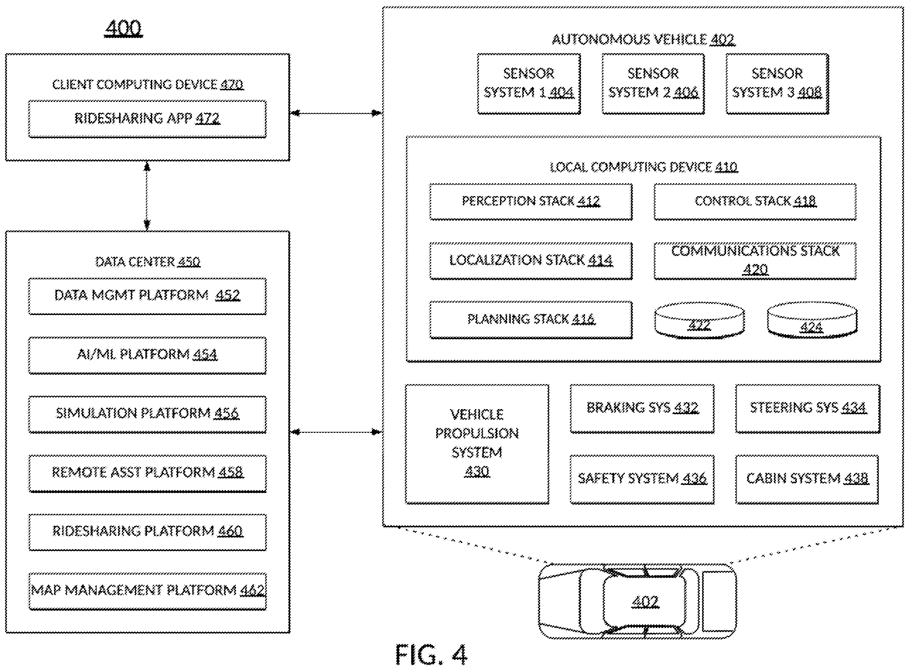

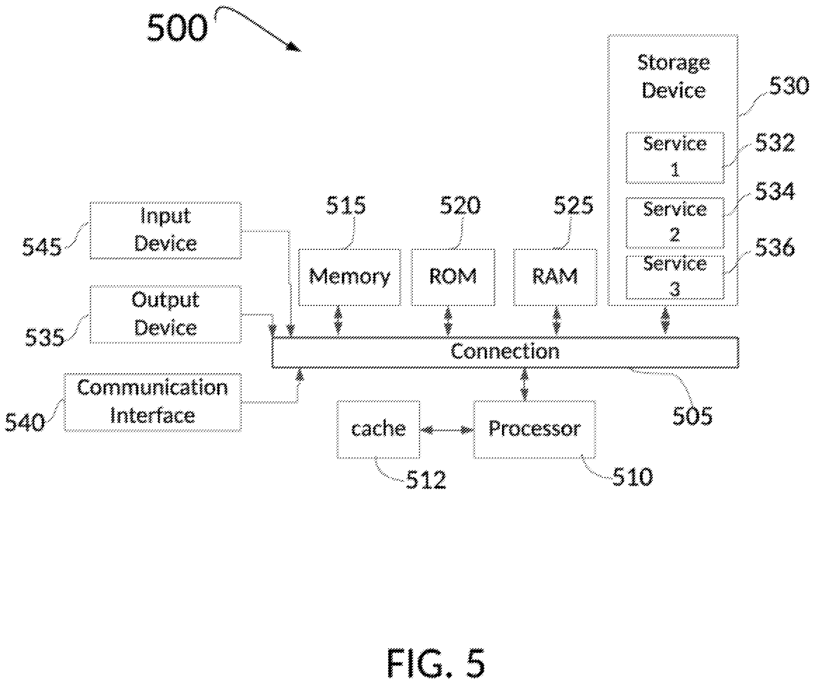

FIG. 4 illustrates an example system environment that can be used to facilitate AV dispatch and operations, according to some aspects of the disclosed technology. FIG. 4 illustrates an example of an AV management system 500 of FIG. 5. One of ordinary skill in the art will understand that, for the AV management system 400 and any system discussed in the present disclosure, there can be additional or fewer components in similar or alternative configurations. The illustrations and examples provided in the present disclosure are for conciseness and clarity. Other embodiments may include different numbers and/or types of elements, but one of ordinary skill the art will appreciate that such variations do not depart from the scope of the present disclosure.

In this example, the AV management system 400 includes an AV 402, a data center 450, and a client computing device 470. The AV 402, the data center 450, and the client computing device 470 can communicate with one another over one or more networks (not shown), such as a public network (e.g., the Internet, an Infrastructure as a Service (IaaS) network, a Platform as a Service (PaaS) network, a Software as a Service (SaaS) network, other Cloud Service Provider (CSP) network, etc.), a private network (e.g., a Local Area Network (LAN), a private cloud, a Virtual Private Network (VPN), etc.), and/or a hybrid network (e.g., a multi-cloud or hybrid cloud network, etc.).

AV 402 can navigate about roadways without a human driver based on sensor signals generated by multiple sensor systems 404, 406, and 408. The sensor systems 404-408 can include different types of sensors and can be arranged about the AV 402. For instance, the sensor systems 404-408 can comprise Inertial Measurement Units (IMUs), cameras (e.g., still image cameras, video cameras, etc.), light sensors (e.g., LIDAR systems, ambient light sensors, infrared sensors, etc.), RADAR systems, GPS receivers, audio sensors (e.g., microphones, Sound Navigation and Ranging (SONAR) systems, ultrasonic sensors, etc.), engine sensors, speedometers, tachometers, odometers, altimeters, tilt sensors, impact sensors, airbag sensors, seat occupancy sensors, open/closed door sensors, tire pressure sensors, rain sensors, and so forth. For example, the sensor system 404 can be a camera system, the sensor system 406 can be a LIDAR system, and the sensor system 408 can be a RADAR system. Other embodiments may include any other number and type of sensors.

AV 402 can also include several mechanical systems that can be used to maneuver or operate AV 402. For instance, the mechanical systems can include vehicle propulsion system 430, braking system 432, steering system 434, safety system 436, and cabin system 438, among other systems. Vehicle propulsion system 430 can include an electric motor, an internal combustion engine, or both. The braking system 432 can include an engine brake, brake pads, actuators, and/or any other suitable componentry configured to assist in decelerating AV 402. The steering system 434 can include suitable componentry configured to control the direction of movement of the AV 402 during navigation. Safety system 436 can include lights and signal indicators, a parking brake, airbags, and so forth. The cabin system 438 can include cabin temperature control systems, in-cabin entertainment systems, and so forth. In some embodiments, the AV 402 may not include human driver actuators (e.g., steering wheel, handbrake, foot brake pedal, foot accelerator pedal, turn signal lever, window wipers, etc.) for controlling the AV 402. Instead, the cabin system 438 can include one or more client interfaces (e.g., Graphical User Interfaces (GUIs), Voice User Interfaces (VUIs), etc.) for controlling certain aspects of the mechanical systems 430-438.

AV 402 can additionally include a local computing device 410 that is in communication with the sensor systems 404-408, the mechanical systems 430-438, the data center 450, and the client computing device 470, among other systems. The local computing device 410 can include one or more processors and memory, including instructions that can be executed by the one or more processors. The instructions can make up one or more software stacks or components responsible for controlling the AV 402; communicating with the data center 450, the client computing device 470, and other systems; receiving inputs from riders, passengers, and other entities within the AV's environment; logging metrics collected by the sensor systems 404-408; and so forth. In this example, the local computing device 410 includes a perception stack 412, a mapping and localization stack 414, a planning stack 416, a control stack 418, a communications stack 420, an HD geospatial database 422, and an AV operational database 424, among other stacks and systems.

Perception stack 412 can enable the AV 402 to "see" (e.g., via cameras, LIDAR sensors, infrared sensors, etc.), "hear" (e.g., via microphones, ultrasonic sensors, RADAR, etc.), and "feel" (e.g., pressure sensors, force sensors, impact sensors, etc.) its environment using information from the sensor systems 404-408, the mapping and localization stack 414, the HD geospatial database 422, other components of the AV, and other data sources (e.g., the data center 450, the client computing device 470, third-party data sources, etc.). The perception stack 412 can detect and classify objects and determine their current and predicted locations, speeds, directions, and the like. In addition, the perception stack 412 can determine the free space around the AV 402 (e.g., to maintain a safe distance from other objects, change lanes, park the AV, etc.). The perception stack 412 can also identify environmental uncertainties, such as where to look for moving objects, flag areas that may be obscured or blocked from view, and so forth.

Mapping and localization stack 414 can determine the AV's position and orientation (pose) using different methods from multiple systems (e.g., GPS, IMUs, cameras, LIDAR, RADAR, ultrasonic sensors, the HD geospatial database 422, etc.). For example, in some embodiments, the AV 402 can compare sensor data captured in real-time by the sensor systems 404-408 to data in the HD geospatial database 422 to determine its precise (e.g., accurate to the order of a few centimeters or less) position and orientation. The AV 402 can focus its search based on sensor data from one or more first sensor systems (e.g., GPS) by matching sensor data from one or more second sensor systems (e.g., LIDAR). If the mapping and localization information from one system is unavailable, the AV 402 can use mapping and localization information from a redundant system and/or from remote data sources.

The planning stack 416 can determine how to maneuver or operate the AV 402 safely and efficiently in its environment. For example, the planning stack 416 can receive the location, speed, and direction of the AV 402, geospatial data, data regarding objects sharing the road with the AV 402 (e.g., pedestrians, bicycles, vehicles, ambulances, buses, cable cars, trains, traffic lights, lanes, road markings, etc.) or certain events occurring during a trip (e.g., emergency vehicle blaring a siren, intersections, occluded areas, street closures for construction or street repairs, double-parked cars, etc.), traffic rules and other safety standards or practices for the road, user input, and other relevant data for directing the AV 402 from one point to another. The planning stack 416 can determine multiple sets of one or more mechanical operations that the AV 402 can perform (e.g., go straight at a specified rate of acceleration, including maintaining the same speed or decelerating; turn on the left blinker, decelerate if the AV is above a threshold range for turning, and turn left; turn on the right blinker, accelerate if the AV is stopped or below the threshold range for turning, and turn right; decelerate until completely stopped and reverse; etc.), and select the best one to meet changing road conditions and events. If something unexpected happens, the planning stack 416 can select from multiple backup plans to carry out. For example, while preparing to change lanes to turn right at an intersection, another vehicle may aggressively cut into the destination lane, making the lane change unsafe. The planning stack 416 could have already determined an alternative plan for such an event, and upon its occurrence, help to direct the AV 402 to go around the block instead of blocking a current lane while waiting for an opening to change lanes.

The control stack 418 can manage the operation of the vehicle propulsion system 430, the braking system 432, the steering system 434, the safety system 436, and the cabin system 438. The control stack 418 can receive sensor signals from the sensor systems 404-408 as well as communicate with other stacks or components of the local computing device 410 or a remote system (e.g., the data center 450) to effectuate operation of the AV 402. For example, the control stack 418 can implement the final path or actions from the multiple paths or actions provided by the planning stack 416. This can involve turning the routes and decisions from the planning stack 416 into commands for the actuators that control the AV's steering, throttle, brake, and drive unit.

The communication stack 420 can transmit and receive signals between the various stacks and other components of the AV 402 and between the AV 402, the data center 450, the client computing device 470, and other remote systems. The communication stack 420 can enable the local computing device 410 to exchange information remotely over a network, such as through an antenna array or interface that can provide a metropolitan WIFI network connection, a mobile or cellular network connection (e.g., Third Generation (3G), Fourth Generation (4G), Long-Term Evolution (LTE), 5th Generation (5G), etc.), and/or other wireless network connection (e.g., License Assisted Access (LAA), Citizens Broadband Radio Service (CBRS), MULTEFIRE, etc.). The communication stack 420 can also facilitate local exchange of information, such as through a wired connection (e.g., a user's mobile computing device docked in an in-car docking station or connected via Universal Serial Bus (USB), etc.) or a local wireless connection (e.g., Wireless Local Area Network (WLAN), Bluetooth®, infrared, etc.).

The HD geospatial database 422 can store HD maps and related data of the streets upon which the AV 402 travels. In some embodiments, the HD maps and related data can comprise multiple layers, such as an areas layer, a lanes and boundaries layer, an intersections layer, a traffic controls layer, and so forth. The areas layer can include geospatial information indicating geographic areas that are drivable (e.g., roads, parking areas, shoulders, etc.) or not drivable (e.g., medians, sidewalks, buildings, etc.), drivable areas that constitute links or connections (e.g., drivable areas that form the same road) versus intersections (e.g., drivable areas where two or more roads intersect), and so on. The lanes and boundaries layer can include geospatial information of road lanes (e.g., lane centerline, lane boundaries, type of lane boundaries, etc.) and related attributes (e.g., direction of travel, speed limit, lane type, etc.). The lanes and boundaries layer can also include 3D attributes related to lanes (e.g., slope, elevation, curvature, etc.). The intersections layer can include geospatial information of intersections (e.g., crosswalks, stop lines, turning lane centerlines and/or boundaries, etc.) and related attributes (e.g., permissive, protected/permissive, or protected only left turn lanes; legal or illegal U-turn lanes; permissive or protected only right turn lanes; etc.). The traffic controls lane can include geospatial information of traffic signal lights, traffic signs, and other road objects and related attributes.

The AV operational database 424 can store raw AV data generated by the sensor systems 404-408 and other components of the AV 402 and/or data received by the AV 402 from remote systems (e.g., the data center 450, the client computing device 470, etc.). In some embodiments, the raw AV data can include HD LIDAR point cloud data, image data, RADAR data, GPS data, and other sensor data that the data center 450 can use for creating or updating AV geospatial data as discussed further below with respect to FIG. 2 and elsewhere in the present disclosure.

The data center 450 can be a private cloud (e.g., an enterprise network, a colocation provider network, etc.), a public cloud (e.g., an Infrastructure as a Service (IaaS) network, a Platform as a Service (PaaS) network, a Software as a Service (SaaS) network, or other Cloud Service Provider (CSP) network), a hybrid cloud, a multicloud, and so forth. The data center 450 can include one or more computing devices remote to the local computing device 410 for managing a fleet of AVs and AV-related services. For example, in addition to managing the AV 402, the data center 450 may also support a ridesharing service, a delivery service, a remote/roadside assistance service, street services (e.g., street mapping, street patrol, street cleaning, street metering, parking reservation, etc.), and the like.

The data center 450 can send and receive various signals to and from the AV 402 and client computing device 470. These signals can include sensor data captured by the sensor systems 404-408, roadside assistance requests, software updates, ridesharing pick-up and drop-off instructions, and so forth. In this example, the data center 450 includes a data management platform 452, an Artificial Intelligence/Machine Learning (AI/ML) platform 454, a simulation platform 456, a remote assistance platform 458, a ridesharing platform 460, and map management system platform 462, among other systems.

Data management platform 452 can be a "big data" system capable of receiving and transmitting data at high velocities (e.g., near real-time or real-time), processing a large variety of data, and storing large volumes of data (e.g., terabytes, petabytes, or more of data). The varieties of data can include data having different structure (e.g., structured, semi-structured, unstructured, etc.), data of different types (e.g., sensor data, mechanical system data, ridesharing service, map data, audio, video, etc.), data associated with different types of data stores (e.g., relational databases, key-value stores, document databases, graph databases, column-family databases, data analytic stores, search engine databases, time series databases, object stores, file systems, etc.), data originating from different sources (e.g., AVs, enterprise systems, social networks, etc.), data having different rates of change (e.g., batch, streaming, etc.), or data having other heterogeneous characteristics. The various platforms and systems of the data center 450 can access data stored by the data management platform 452 to provide their respective services.

The AI/ML platform 454 can provide the infrastructure for training and evaluating machine learning algorithms for operating the AV 402, the simulation platform 456, the remote assistance platform 458, the ridesharing platform 460, the map management system platform 462, and other platforms and systems. Using the AI/ML platform 454, data scientists can prepare data sets from the data management platform 452; select, design, and train machine learning models; evaluate, refine, and deploy the models; maintain, monitor, and retrain the models; and so on.

The simulation platform 456 can enable testing and validation of the algorithms, machine learning models, neural networks, and other development efforts for the AV 402, the remote assistance platform 458, the ridesharing platform 460, the map management system platform 462, and other platforms and systems. The simulation platform 456 can replicate a variety of driving environments and/or reproduce real-world scenarios from data captured by the AV 402, including rendering geospatial information and road infrastructure (e.g., streets, lanes, crosswalks, traffic lights, stop signs, etc.) obtained from the map management system platform 462; modeling the behavior of other vehicles, bicycles, pedestrians, and other dynamic elements; simulating inclement weather conditions, different traffic scenarios; and so on.

The remote assistance platform 458 can generate and transmit instructions regarding the operation of the AV 402. For example, in response to an output of the AI/ML platform 454 or other system of the data center 450, the remote assistance platform 458 can prepare instructions for one or more stacks or other components of the AV 402.

The ridesharing platform 460 can interact with a customer of a ridesharing service via a ridesharing application 472 executing on the client computing device 470. The client computing device 470 can be any type of computing system, including a server, desktop computer, laptop, tablet, smartphone, smart wearable device (e.g., smart watch, smart eyeglasses or other Head-Mounted Display (HMD), smart ear pods or other smart in-ear, on-ear, or over-ear device, etc.), gaming system, or other general purpose computing device for accessing the ridesharing application 472. The client computing device 470 can be a customer's mobile computing device or a computing device integrated with the AV 402 (e.g., the local computing device 410). The ridesharing platform 460 can receive requests to be picked up or dropped off from the ridesharing application 472 and dispatch the AV 402 for the trip.

Map management system platform 462 can provide a set of tools for the manipulation and management of geographic and spatial (geospatial) and related attribute data. The data management platform 452 can receive LIDAR point cloud data, image data (e.g., still image, video, etc.), RADAR data, GPS data, and other sensor data (e.g., raw data) from one or more AVs 402, UAVs, satellites, third-party mapping services, and other sources of geospatially referenced data. The raw data can be processed, and map management system platform 462 can render base representations (e.g., tiles (2D), bounding volumes (3D), etc.) of the AV geospatial data to enable users to view, query, label, edit, and otherwise interact with the data. Map management system platform 462 can manage workflows and tasks for operating on the AV geospatial data. Map management system platform 462 can control access to the AV geospatial data, including granting or limiting access to the AV geospatial data based on user-based, role-based, group-based, task-based, and other attribute-based access control mechanisms. Map management system platform 462 can provide version control for the AV geospatial data, such as to track specific changes that (human or machine) map editors have made to the data and to revert changes when necessary. Map management system platform 462 can administer release management of the AV geospatial data, including distributing suitable iterations of the data to different users, computing devices, AVs, and other consumers of HD maps. Map management system platform 462 can provide analytics regarding the AV geospatial data and related data, such as to generate insights relating to the throughput and quality of mapping tasks.

In some embodiments, the map viewing services of map management system platform 462 can be modularized and deployed as part of one or more of the platforms and systems of the data center 450. For example, the AI/ML platform 454 may incorporate the map viewing services for visualizing the effectiveness of various object detection or object classification models, the simulation platform 456 may incorporate the map viewing services for recreating and visualizing certain driving scenarios, the remote assistance platform 458 may incorporate the map viewing services for replaying traffic incidents to facilitate and coordinate aid, the ridesharing platform 460 may incorporate the map viewing services into the client application 472 to enable passengers to view the AV 402 in transit en route to a pick-up or drop-off location, and so on.

FIG. 5 illustrates an example processor-based system with which some aspects of the subject technology can be implemented. For example, processor-based system 500 can be any computing device making up internal computing system 510, remote computing system 550, a passenger device executing the rideshare app 570, internal computing device 530, or any component thereof in which the components of the system are in communication with each other using connection 505. Connection 505 can be a physical connection via a bus, or a direct connection into processor 510, such as in a chipset architecture. Connection 505 can also be a virtual connection, networked connection, or logical connection.

In some embodiments, computing system 500 is a distributed system in which the functions described in this disclosure can be distributed within a datacenter, multiple data centers, a peer network, etc. In some embodiments, one or more of the described system components represents many such components each performing some or all of the function for which the component is described. In some embodiments, the components can be physical or virtual devices.

Example system 500 includes at least one processing unit (CPU or processor) 510 and connection 505 that couples various system components including system memory 515, such as read-only memory (ROM) 520 and random-access memory (RAM) 525 to processor 510. Computing system 500 can include a cache of high-speed memory 512 connected directly with, in close proximity to, or integrated as part of processor 510.

Processor 510 can include any general-purpose processor and a hardware service or software service, such as services 532, 534, and 536 stored in storage device 530, configured to control processor 510 as well as a special-purpose processor where software instructions are incorporated into the actual processor design. Processor 510 may essentially be a completely self-contained computing system, containing multiple cores or processors, a bus, memory controller, cache, etc. A multi-core processor may be symmetric or asymmetric.

To enable user interaction, computing system 500 includes an input device 545, which can represent any number of input mechanisms, such as a microphone for speech, a touch-sensitive screen for gesture or graphical input, keyboard, mouse, motion input, speech, etc. Computing system 500 can also include output device 535, which can be one or more of a number of output mechanisms known to those of skill in the art. In some instances, multimodal systems can enable a user to provide multiple types of input/output to communicate with computing system 500. Computing system 500 can include communications interface 540, which can generally govern and manage the user input and system output. The communication interface may perform or facilitate receipt and/or transmission wired or wireless communications via wired and/or wireless transceivers, including those making use of an audio jack/plug, a microphone jack/plug, a universal serial bus (USB) port/plug, an Apple® Lightning® port/plug, an Ethernet port/plug, a fiber optic port/plug, a proprietary wired port/plug, a BLUETOOTH® wireless signal transfer, a BLUETOOTH® low energy (BLE) wireless signal transfer, an IBEACON® wireless signal transfer, a radio-frequency identification (RFID) wireless signal transfer, near-field communications (NFC) wireless signal transfer, dedicated short range communication (DSRC) wireless signal transfer, 802.11 Wi-Fi wireless signal transfer, wireless local area network (WLAN) signal transfer, Visible Light Communication (VLC), Worldwide Interoperability for Microwave Access (WiMAX), Infrared (IR) communication wireless signal transfer, Public Switched Telephone Network (PSTN) signal transfer, Integrated Services Digital Network (ISDN) signal transfer, 3G/4G/5G/LTE cellular data network wireless signal transfer, ad-hoc network signal transfer, radio wave signal transfer, microwave signal transfer, infrared signal transfer, visible light signal transfer, ultraviolet light signal transfer, wireless signal transfer along the electromagnetic spectrum, or some combination thereof.

Communication interface 540 may also include one or more Global Navigation Satellite System (GNSS) receivers or transceivers that are used to determine a location of the computing system 500 based on receipt of one or more signals from one or more satellites associated with one or more GNSS systems. GNSS systems include, but are not limited to, the US-based Global Positioning System (GPS), the Russia-based Global Navigation Satellite System (GLONASS), the China-based BeiDou Navigation Satellite System (BDS), and the Europe-based Galileo GNSS. There is no restriction on operating on any particular hardware arrangement, and therefore the basic features here may easily be substituted for improved hardware or firmware arrangements as they are developed.

Storage device 530 can be a non-volatile and/or non-transitory and/or computer-readable memory device and can be a hard disk or other types of computer readable media which can store data that are accessible by a computer, such as magnetic cassettes, flash memory cards, solid state memory devices, digital versatile disks, cartridges, a floppy disk, a flexible disk, a hard disk, magnetic tape, a magnetic strip/stripe, any other magnetic storage medium, flash memory, memristor memory, any other solid-state memory, a compact disc read only memory (CD-ROM) optical disc, a rewritable compact disc (CD) optical disc, digital video disk (DVD) optical disc, a blu-ray disc (BDD) optical disc, a holographic optical disk, another optical medium, a secure digital (SD) card, a micro secure digital (microSD) card, a Memory Stick® card, a smartcard chip, a EMV chip, a subscriber identity module (SIM) card, a mini/micro/nano/pico SIM card, another integrated circuit (IC) chip/card, random access memory (RAM), static RAM (SRAM), dynamic RAM (DRAM), read-only memory (ROM), programmable read-only memory (PROM), erasable programmable read-only memory (EPROM), electrically erasable programmable read-only memory (EEPROM), flash EPROM (FLASHEPROM), cache memory (L1/L2/L3/L4/L5/L#), resistive random-access memory (RRAM/ReRAM), phase change memory (PCM), spin transfer torque RAM (STT-RAM), another memory chip or cartridge, and/or a combination thereof.

Storage device 530 can include software services, servers, services, etc., that when the code that defines such software is executed by the processor 510, it causes the system to perform a function. In some embodiments, a hardware service that performs a particular function can include the software component stored in a computer-readable medium in connection with the necessary hardware components, such as processor 510, connection 505, output device 535, etc., to carry out the function.

As understood by those of skill in the art, machine-learning based classification techniques can vary depending on the desired implementation. For example, machine-learning classification schemes can utilize one or more of the following, alone or in combination: hidden Markov models; recurrent neural networks; convolutional neural networks (CNNs); deep learning; Bayesian symbolic methods; general adversarial networks (GANs); support vector machines; image registration methods; applicable rulebased system. Where regression algorithms are used, they may include including but are not limited to: a Stochastic Gradient Descent Regressor, and/or a Passive Aggressive Regressor, etc.

Machine learning classification models can also be based on clustering algorithms (e.g., a Mini-batch K-means clustering algorithm), a recommendation algorithm (e.g., a Miniwise Hashing algorithm, or Euclidean Locality-Sensitive Hashing (LSH) algorithm), and/or an anomaly detection algorithm, such as a Local outlier factor. Additionally, machine-learning models can employ a dimensionality reduction approach, such as, one or more of: a Mini-batch Dictionary Learning algorithm, an Incremental Principal Component Analysis (PCA) algorithm, a Latent Dirichlet Allocation algorithm, and/or a Mini-batch K-means algorithm, etc.

Embodiments within the scope of the present disclosure may also include tangible and/or non-transitory computer-readable storage media or devices for carrying or having computer-executable instructions or data structures stored thereon. Such tangible computer-readable storage devices can be any available device that can be accessed by a general purpose or special purpose computer, including the functional design of any special purpose processor as described above. By way of example, and not limitation, such tangible computer-readable devices can include RAM, ROM, EEPROM, CD-ROM or other optical disk storage, magnetic disk storage or other magnetic storage devices, or any other device which can be used to carry or store desired program code in the form of computer-executable instructions, data structures, or processor chip design. When information or instructions are provided via a network or another communications connection (either hardwired, wireless, or combination thereof) to a computer, the computer properly views the connection as a computer-readable medium. Thus, any such connection is properly termed a computer-readable medium. Combinations of the above should also be included within the scope of the computer-readable storage devices.

Computer-executable instructions include, for example, instructions and data which cause a general-purpose computer, special purpose computer, or special purpose processing device to perform a certain function or group of functions. Computer-executable instructions also include program modules that are executed by computers in stand-alone or network environments. Generally, program modules include routines, programs, components, data structures, objects, and the functions inherent in the design of special-purpose processors, etc. that perform tasks or implement abstract data types. Computer-executable instructions, associated data structures, and program modules represent examples of the program code means for executing steps of the methods disclosed herein. The particular sequence of such executable instructions or associated data structures represents examples of corresponding acts for implementing the functions described in such steps.

Other embodiments of the disclosure may be practiced in network computing environments with many types of computer system configurations, including personal computers, hand-held devices, multi-processor systems, microprocessor-based or programmable consumer electronics, network PCs, minicomputers, mainframe computers, and the like. Embodiments may also be practiced in distributed computing environments where tasks are performed by local and remote processing devices that are linked (either by hardwired links, wireless links, or by a combination thereof) through a communications network. In a distributed computing environment, program modules may be located in both local and remote memory storage devices.

The various embodiments described above are provided by way of illustration only and should not be construed to limit the scope of the disclosure. For example, the principles herein apply equally to optimization as well as general improvements. Various modifications and changes may be made to the principles described herein without following the example embodiments and applications illustrated and described herein, and without departing from the spirit and scope of the disclosure. Claim language reciting "at least one of" a set indicates that one member of the set or multiple members of the set satisfy the claim.

NUMBERED STATEMENTS OF INVENTION

1. A radar system element, comprising:

a first reference signal antenna affixed to a first printed circuit board (PCB); and
a transmission antenna element affixed to the first PCB, wherein the transmission antenna is coupled to the first reference signal antenna via a radar chipset, and
wherein the first reference signal antenna is configured to wirelessly transact synchronization signals with a second radar system element.

2. The radar system element of statement 1, wherein the first reference signal antenna is configured to wirelessly transact the synchronization signals with the second radar system element via a second reference signal antenna affixed to a second PCB when the second reference signal antenna is physically adjacent to the first reference signal antenna.

3. The radar system element of statement 1, further comprising:
a signal amplifier coupled between the first reference signal antenna and the radar chipset.

4. The radar system element of statement 1, wherein the transmission antenna is configured to transmit and receive wireless signals between 20GHz and 90GHz.

5. The radar system element of statement 1, wherein the radar chipset comprises a Monolithic Microwave Integrated Circuit (MMIC).

6. The radar system element of statement 5, wherein the MMIC comprises a signal processor.

7. The radar system element of statement 1, wherein timing of one or more signals are synchronized based on operation of a phase-locked loop (PLL) circuit.

8. The radar system element of statement 1, wherein the radar chipset is configured to perform phase shifting of timing based on trace lengths associated with a length of trace connected to at least one of the first reference signal antenna or a second reference signal antenna of the second radar system element.

9. A radar system, comprising:

a first radar system element comprising a first reference signal antenna coupled to a first transmission antenna; and
a second radar system element comprising a second reference signal antenna coupled to a second transmission antenna, and wherein the first radar system element and the second radar system element are configured to wirelessly transact synchronization signals via the first reference signal antenna and the second reference signal antenna.

10. The radar system of statement 9, wherein the first reference signal antenna is coupled to the first transmission antenna via a first radar chipset, and wherein the second reference signal antenna is coupled to the second transmission antenna via a second radar chipset.

11. The radar system of statement 10, wherein the radar chipset is configured to perform phase shifting of timing based on trace lengths associated with a length of trace connected to at least one of the first reference signal antenna or a second reference signal antenna of the second radar system element.

12. The radar system of statement 10, wherein the first radar chipset and the second radar chipset each comprise a Monolithic Microwave Integrated Circuit (MMIC).

13. The radar system of statement 12, wherein the MMIC comprises a signal processor.

14. The radar system of statement 9, further comprising:

a first signal amplifier coupled to the first reference signal antenna; and
a second signal amplifier coupled to the second reference signal antenna.

15. The radar system of statement 9, wherein the first transmission antenna and the second transmission antenna are configured to transmit and receive wireless signals between 20GHz and 90GHz.

16. The radar system of statement 9, wherein timing of one or more signals are synchronized based on operation of a phase-locked loop (PLL) circuit.

17. A method for assembling a radar system, comprising:

coupling a first radar system element to a first transmission antenna, wherein the first radar system element includes a first reference signal antenna; and
coupling a second radar system element to a second transmission antenna, wherein the second radar system element includes a second reference signal antenna, and wherein the first radar system element and the second radar system element are configured to wirelessly transact synchronization signals via the first reference signal antenna and the second reference signal antenna.

18. The method of statement 17, wherein the first reference signal antenna is coupled to the first transmission antenna via a first radar chipset, and wherein the second reference signal antenna is coupled to the second transmission antenna via a second radar chipset.

19. The method of statement 18, wherein the radar chipset is configured to perform phase shifting of timing based on trace lengths associated with a length of trace connected to at least one of the first reference signal antenna or a second reference signal antenna of the second radar system element.

20. The method of statement 18, wherein the first radar chipset and the second radar chipset each comprise a Monolithic Microwave Integrated Circuit (MMIC).

**Claims**

1. A radar system element, comprising:

a first reference signal antenna; and
a transmission antenna element, wherein the transmission antenna is coupled to the first reference signal antenna, and
wherein the first reference signal antenna is configured to wirelessly transact synchronization signals with a second radar system element.

2. The radar system element of claim 1, wherein the first reference signal antenna and the transmission antenna element are affixed to a first printed circuit board, PCB, wherein the transmission antenna is coupled to the first reference signal antenna via a radar chipset.

3. The radar system element of claim 2, wherein the first reference signal antenna is configured to wirelessly transact the synchronization signals with the second radar system element via a second reference signal antenna affixed to a second PCB when the second reference signal antenna is physically adjacent to the first reference signal antenna.

4. The radar system element of claim 2 or 3, further comprising:
a signal amplifier coupled between the first reference signal antenna and the radar chipset.

5. The radar system element of any preceding claim, wherein the transmission antenna is configured to transmit and receive wireless signals between 20GHz and 90GHz.

6. The radar system element of any of claims 2 to 5 when dependent on claim 2, wherein the radar chipset comprises a Monolithic Microwave Integrated Circuit (MMIC), wherein the MMIC comprises a signal processor.

7. The radar system element of any preceding claim, wherein timing of one or more signals are synchronized based on operation of a phase-locked loop (PLL) circuit.

8. The radar system element of any of claims 2 to 7 when dependent on claim 2, wherein the radar chipset is configured to perform phase shifting of timing based on trace lengths associated with a length of trace connected to at least one of the first reference signal antenna or a second reference signal antenna of the second radar system element.

9. A radar system, comprising:

the radar system element of any preceding claim; and
a second radar system element comprising the second reference signal antenna coupled to a second transmission antenna, and wherein the first radar system element and the second radar system element are configured to wirelessly transact synchronization signals via the first reference signal antenna and the second reference signal antenna.

10. The radar system of claim 9, wherein the first reference signal antenna is coupled to the first transmission antenna via a first radar chipset, and wherein the second reference signal antenna is coupled to the second transmission antenna via a second radar chipset.

11. A method for assembling a radar system, comprising:

coupling a first radar system element to a first transmission antenna, wherein the first radar system element includes a first reference signal antenna; and
coupling a second radar system element to a second transmission antenna, wherein the second radar system element includes a second reference signal antenna, and
wherein the first radar system element and the second radar system element are configured to wirelessly transact synchronization signals via the first reference signal antenna and the second reference signal antenna.

12. The method of claim 11, wherein the first reference signal antenna is coupled to the first transmission antenna via a first radar chipset, and wherein the second reference signal antenna is coupled to the second transmission antenna via a second radar chipset.

13. The method of claim 12, wherein the radar chipset is configured to perform phase shifting of timing based on trace lengths associated with a length of trace connected to at least one of the first reference signal antenna or a second reference signal antenna of the second radar system element.

14. The method of claim 12 or 13, wherein the first radar chipset and the second radar chipset each comprise a Monolithic Microwave Integrated Circuit (MMIC).

100-B

120-T

130-T

140-T

120

130

140

120-R

130-R

140-R

| 120 | 130 | 140 |
|---|---|---|
| 110 | | |

100-A

# FIG. 1

# FIG. 2A

FIG. 2B

Coupling a 1st Radar Signal Element to a 1st
Transmission Antenna
310

Coupling a 2nd Radar Signal Element to a
2nd Transmission Antenna
320

Coupling a Timing Synchronization Signal
Between the 1st Radar Signal Element & the
2nd Radar Signal Element 330

Transmitting a Radar Signal Synchronized
with the Timing Synchronization Signal
340

Receiving Reflected Radar Signals
350

Processing the Reflected Radar Signals
360

# FIG. 3

400

AUTONOMOUS VEHICLE 402

SENSOR SYSTEM 1 404

SENSOR SYSTEM 2 406

SENSOR SYSTEM 3 408

LOCAL COMPUTING DEVICE 410

PERCEPTION STACK 412

LOCALIZATION STACK 414

PLANNING STACK 416

CONTROL STACK 418

COMMUNICATIONS STACK 420

422

424

VEHICLE PROPULSION SYSTEM 430

BRAKING SYS 432

STEERING SYS 434

SAFETY SYSTEM 436

CABIN SYSTEM 438

402

CLIENT COMPUTING DEVICE 470

RIDESHARING APP 472

DATA CENTER 450

DATA MGMT PLATFORM 452

AI/ML PLATFORM 454

SIMULATION PLATFORM 456

REMOTE ASST PLATFORM 458

RIDESHARING PLATFORM 460

MAP MANAGEMENT PLATFORM 462

FIG. 4

FIG. 5

Europäisches
Patentamt
European
Patent Office
Office européen
des brevets

# EUROPEAN SEARCH REPORT

Application Number

EP 22 20 7872

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 499 264 A1 (NXP BV [NL]) 19 June 2019 (2019-06-19) * figure 5 * * abstract * * paragraphs [0009], [0047], [0050] * ----- | 1-14 | INV. G01S7/03 ADD. G01S13/86 G01S13/931 |
| X | WO 2017/196991 A1 (GOOGLE LLC [US]) 16 November 2017 (2017-11-16) * figures 13A,13B * * abstract * * paragraphs [0245], [0246], [0257] * ----- | 1-14 | |
| X | US 2008/252546 A1 (MOHAMADI FARROKH [US]) 16 October 2008 (2008-10-16) * figure 5 * * abstract * * paragraph [0006] * ----- | 1-14 | |

| | TECHNICAL FIELDS SEARCHED (IPC) |
|---|---|
| | G01S |

The present search report has been drawn up for all claims

| Place of search | Date of completion of the search | Examiner |
|---|---|---|
| Munich | 24 March 2023 | Alberga, Vito |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 20 7872

This annex lists the patent family members relating to the patent documents cited in the above-mentioned European search report.
The members are as contained in the European Patent Office EDP file on
The European Patent Office is in no way liable for these particulars which are merely given for the purpose of information.

24-03-2023

| Patent document cited in search report | | Publication date | Patent family member(s) | | Publication date |
|---|---|---|---|---|---|
| EP 3499264 | A1 | 19-06-2019 | EP | 3499264 A1 | 19-06-2019 |
| | | | US | 2019178983 A1 | 13-06-2019 |
| WO 2017196991 | A1 | 16-11-2017 | CN | 108700645 A | 23-10-2018 |
| | | | EP | 3455644 A1 | 20-03-2019 |
| | | | JP | 6847968 B2 | 24-03-2021 |
| | | | JP | 2019515246 A | 06-06-2019 |
| | | | JP | 2021099361 A | 01-07-2021 |
| | | | KR | 20180105174 A | 27-09-2018 |
| | | | US | 2017328997 A1 | 16-11-2017 |
| | | | US | 2020233079 A1 | 23-07-2020 |
| | | | WO | 2017196991 A1 | 16-11-2017 |
| US 2008252546 | A1 | 16-10-2008 | NONE | | |

EPO FORM P0459

For more details about this annex : see Official Journal of the European Patent Office, No. 12/82